Europäisches Patentamt

European Patent Office

Office européen des brevets

(11) Veröffentlichungsnummer: **0 217 160**
B1

# EUROPÄISCHE PATENTSCHRIFT

(45) Veröffentlichungstag der Patentschrift:
18.07.90

(21) Anmeldenummer: 86112150.7

(22) Anmeldetag: 02.09.86

(51) Int. Cl.⁵: **H05K 7/20**, H05K 7/14,
H05K 7/18, H05K 5/00

(54) Profil-Trägerplatte für elektrische Inneneinbauten mit wärmeerzeugenden Bauelementen.

(30) Priorität: 05.09.85 DE 3531708

(43) Veröffentlichungstag der Anmeldung:
08.04.87 Patentblatt 87/15

(45) Bekanntmachung des Hinweises auf die Patenterteilung:
18.07.90 Patentblatt 90/29

(84) Benannte Vertragsstaaten:
CH DE FR GB IT LI NL

(56) Entgegenhaltungen:
EP-A- 0 080 538
EP-A- 0 109 557.
DE-A- 2 443 122
DE-A- 2 523 292
DE-A- 3 110 717

(73) Patentinhaber: Siemens Aktiengesellschaft,
Wittelsbacherplatz 2, D-8000 München 2(DE)
Patentinhaber: ANT Nachrichtentechnik GmbH,
Gerberstrasse 33, D-7150 Backnang(DE)

(72) Erfinder: Riedl, Friedrich, Dipl.-Ing.(FH),
Herbststrasse 15, D-8035 Gauting(DE)
Erfinder: Mayer, Franz, Wastl-Witt-Strasse 11,
D-8000 München 21(DE)
Erfinder: Hirsch, Gerhard, Ing. (grad), Häfnersweg 66,
D-7150 Backnang(DE)
Erfinder: Hohloch, Manfred, Ing., Trailhöferstrasse 86,
D-7151 Auenwald(DE)

(74) Vertreter: Fuchs, Franz-Josef, Dr.-Ing. et al,
Postfach 22 13 17, D-8000 München 22(DE)

## Beschreibung

Die Erfindung betrifft eine Profil-Trägerplatte für mit wärmeerzeugenden elektrischen Bauelementen versehene Inneneinbauten, wie z.B. Leiterplatten oder Baugruppen, insbesondere der Nachrichtentechnik, z.B. Bodenplatte für einen Gehäusemantel eines elektrischen Gerätes, mit zu zwei einander parallel gegenüberliegenden Plattenrändern parallelen Profilschienen, die mit einer zu den Inneneinbauten hin offenen T-Nut ausgebildet sind und mit zueinander und zu den Profilschienen parallelen Kühlrippen. Eine derartige Profil Trägerplatte ist aus der DE-A 2 523 292 bekannt.

In Geräte der Elektrotechnik oder Elektronik werden elektrische Inneneinbauten mit wärmeerzeugenden Bauelementen, wie z.B. Leiterplatten oder Baugruppen, eingebaut. Die Gehäuse oder Gestelle der Geräte müssen daher zur Aufnahme und Führung dieser Inneneinbauten in geeigneter Weise ausgebildet sein. Man hat dazu Profil-Trägerplatten vorgesehen, die als Baugruppenträger zum Einbau in Gestelle geeignet oder z.B. die Boden- und/oder Deckplatte eines Gehäusemantels bilden.

Durch die DE-AS 2 523 292 ist ein Gehäuse für elektrotechnische Geräte bekannt, das einen kastenförmigen Rahmen oder Gehäusemantel aufweist, der aus zwei Mittelteilen, nämlich einer Boden- und einer Deckplatte, sowie zwei damit dicht verbundenen Seitenteilen besteht und an den beiden offenen Seiten mit einer Front- bzw. einer Rückwand dicht verschließbar ist. Die Mittelteile tragen die Inneneinbauten und sind von plattenförmigen, relativ dicken Wänden aus in Richtung der Gehäusebreite verlaufenden Aluminium-Strangpreßprofilen gebildet. Diese Profil-Trägerplatten sind mit mäanderförmigen Vertiefungen, die als T-förmige in die Plattendicke integrierte Nuten ausgebildet sind, für Gleitmuttern versehen, um die in Richtung der Gehäusetiefe verlaufenden, zur Aufnahme und Führung der Inneneinbauten ebenfalls mit T-Nuten ausgebildeten Schienen mit Hilfe von Schraubbefestigungen bzw. der Gleitmuttern in Richtung der Gehäusebreite hin und her verschieben und befestigen zu können. Außerdem ist die Wandung der Profil-Trägerplatten zwischen den T-förmigen Vertiefungen noch mit Hohlräumen versehen.

Aus der DE-OS 31 10 717 ist ein Baugruppenträger mit Führungsleisten und Rastschienen für Leiterplatten bekannt, der aus einer Profil-Trägerplatte relativ dünner Wandstärke besteht, die an der die Führungsleisten und Rastschienen aufnehmenden Seite einen zu zwei einander gegenüberliegenden Plattenrändern parallelen Profilverlauf aufweist. Dabei ist der Baugruppenträger unregelmäßig profiliert, wobei im wesentlichen durch von der Platte hochragende Rippen unterschiedlicher Dicke und Formgebung offene C-, L-, T- oder Kreuznuten gebildet sind. Zwischen den die Rastschienen sowie die Rastnasen der Führungsleisten aufnehmenden Profilierungen sind an der sonst glatten Trägerplatte weitere Profilierungen mit einer nach außen offenen Kreuznut bzw. zwei nach innen offenen C- bzw. T-Nuten gebildet, während in den Randbereichen der Trägerplatte außerhalb des die Rastschienen und Führungsleisten aufnehmenden Bereiches noch parallele Rippen und weitere Nuten unterschiedlicher Form vorgesehen sind. Der Baugruppenträger bietet somit variable Befestigungsmöglichkeiten für Inneneinbauten und ist zur Aufnahme von schraubenlos durch Einschnappen oder Einrasten in die Profilierungen zu halternde Rastschienen und Führungsleisten geeignet ausgebildet.

An Profil-Trägerplatten für elektrische Inneneinbauten mit wärmeerzeugenden Bauelementen werden in der Praxis vielfältige Anforderungen gestellt. So soll eine derartige Profil-Trägerplatte variable Befestigungsmöglichkeiten für die Inneneinbauten bieten, d.h. sowohl für variable, also nicht stationäre, sondern örtlich veränderbare Schraubbefestigungen als auch für schraubenlos durch Einschnappen oder Einrasten zu halternde Rast- und/oder Führungsmittel geeignet sein. Außerdem muß die Trägerplatte eine hohe Formstabilität bei möglichst geringem Gewicht aufweisen. Dies ist insbesondere beim Aufbau von Gehäusen aus Profil-Trägerplatten sowie bei mobilem Geräteeinsatz und/oder bei schwereren Inneneinbauten von besonderer Bedeutung. Schließlich muß bei derartigen Trägerplatten noch für eine möglichst wirkungsvolle Ableitung der von den elektrischen Bauelementen der Inneneinbauten erzeugten Verlustwärme gesorgt werden. Die gleichzeitige Erfüllung dieser Forderungen bereitet jedoch in konstruktiver Hinsicht gewisse Schwierigkeiten.

Bei dem aus der DE-AS 25 23 292 bekannten Gehäuse mit Profil-Trägerplatten aus Aluminium-Strangpreßprofilen für Boden- und Deckplatte des Gehäusemantels ist zwar eine gewisse Variabilität hinsichtlich der Schraubbefestigung von Inneneinbauten und eine gute Formstabilität gegeben, es sind jedoch keine schraubenlos durch Einschnappen oder Einrasten zu halternde Führungssysteme für die Inneneinbauten vorgesehen. Außerdem ist die Trägerplatte relativ dick ausgebildet. Dies ist im Hinblick auf das Gehäusegewicht und auf mobile Einsatzmöglichkeiten von Einfluß. Schließlich sind für die Ableitung der von den elektrischen Bauelementen der Inneneinbauten erzeugten Verlustwärme keine Vorkehrungen getroffen. Die Wärmeableitung wird also im wesentlichen von den bei diesen Trägerplatten vorhandenen, relativ kleinen Wärmeabsorptions- bzw. Wärmekontaktflächen zwischen Trägerplatte und Inneneinbauten bestimmt.

Die aus der DE-OS 3 110 717 bekannte Bauträgerplatte bietet bei der Befestigung von Inneneinbauten durch schraubenlose Halterung der Rast- und Führungselemente mittels Einschnappen oder Einrasten zwar eine größere Variabilität und ist relativ dünn ausgebildet, aber auch bei dieser Bauträgerplatte sind für die Ableitung der von den elektrischen Bauelementen der Leiterplatten erzeugten Verlustwärme keine Vorkehrungen getroffen. Außerdem ist die bekannte Bauträgerplatte insbesondere aufgrund ihrer Breite zum Aufbau von Gehäusen weniger gut geeignet.

Der Erfindung liegt daher die Aufgabe zugrunde, eine Profil-Trägerplatte der eingangs genannten Art zu schaffen, die vor allem eine möglichst gute Wärmeableitung von den Inneneinbauten gewährleistet und außerdem bei variablen Befestigungsmöglichkeiten für die Inneneinbauten sowie bei hoher Formstabilität und möglichst geringem Gewicht sowohl als Einzelträgerplatte als auch zum Aufbau von Gehäusen geeignet ist.

Diese Aufgabe wird bei einer Profil-Trägerplatte der eingangs genannten Art gemäß der Erfindung dadurch gelöst, daß in dem die Inneneinbauten aufnehmenden Bereich der Trägerplatte mindestens drei Profilrippen für Führungsmittel und/oder Befestigungsmittel der Inneneinbauten vorgesehen und in gleichem Abstand voneinander angeordnet sind, daß die Profilrippen aus einem im Vergleich zur Dicke der relativ dünnen Trägerplatte dicken, zur Plattenebene senkrechten Steg und einer auf dem Steg liegend angeordneten C-Profilschiene bestehen, und daß auf derselben Seite der Trägerplatte zwischen jeweils zwei Profilrippen mehrere Kühlrippen in gleichem Abstand voneinander vorgesehen sind, so daß die Trägerplatte auf ein und derselben Seite eine regelmäßige Profilierung mit gleichmäßig innerhalb des die Inneneinbauten aufnehmenden Bereiches verteilten Profil- und Kühlrippen aufweist.

Die bei einer derartigen Profil-Trägerplatte vorgesehene Profilform erfüllt gleichzeitig alle der genannten vielfältigen Anforderungen in konstruktiv einfacher und besonders vorteilhafter Weise. Vor allem ist die Profilform im Hinblick auf eine möglichst wirkungsvolle Ableitung der von den elektrischen Bauelementen der Inneneinbauten erzeugten Verlustwärme von besonderem Vorteil. Durch die Profilform ergeben sich günstige Flächen für Wärmeableitung sowie sehr große Oberflächen für eine gute Wärmeabsorption. Hierbei sind diese Flächen durch den regelmäßigen Abstand der Profil- bzw. Kühlrippen gleichmäßig innerhalb des die Inneneinbauten aufnehmenden Bereiches der Trägerplatte verteilt angeordnet. Dabei bildet der Steg der Profilrippen als Ständer oder Stütze für die die eigentliche Auflage für die Inneneinbauten bzw. deren Führungs- und/oder Befestigungsmittel übernehmende C-Profilschiene eine Art Wärmeableitsteg, während insbesondere durch die Form der Profilrippen und durch die zwischen den Profilrippen angeordneten Kühlrippen vor allem die Oberfläche zur Wärmeabsorption vergrößert wird. Die Kühlrippen bilden zudem noch im Zusammenwirken mit den Profilrippen und der Trägerplatte U-Kanäle, die in kühlungstechnischer Hinsicht noch zusätzlich wirkungsvoll genutzt werden können. Die C-Profilschienen der Profilrippen ergeben neben einer breiten Auflage auch die Möglichkeit, einen guten Wärmekontakt zu den Inneneinbauten herzustellen. Außerdem bietet die Form der C-Profilschienen vielfältige variable Befestigungsmöglichkeiten für die Inneneinbauten bzw. deren Führungs- und/oder Befestigungsmittel, so daß Inneneinbauten wahlweise mittels Gleit- oder Schiebemuttern schraubbar oder schraubenlos bei niedrigem Montagekostenaufwand mit Hilfe von durch Einschnappen oder Einrasten zu halternden Rast-und/oder Führungsmitteln an beliebigen Stellen des Profils befestigt werden können. Dies bietet vielfältige Möglichkeiten für die Befestigung elektrischer oder mechanischer Einbauten unterschiedlicher Bauweise und Größe. Schließlich ist die Profilform sowohl im Hinblick auf die mechanische Stabilität als auch bezüglich des Gewichts der Trägerplatte von Vorteil. Die auf einer relativ dünn auszubildenden Trägerplatte vorgesehene Profilform verleiht der Trägerplatte bei geringstmöglichem Gewicht eine hohe Formstabilität, so daß die Profil-Trägerplatte auch bei hohen mechanischen Belastungen in mobilem und stationärem Einsatz, z.B. beim Einsatz in Fahrzeugen und/oder bei Bestückung mit schweren Baugruppen, gut geeignet und vorteilhaft einsetzbar ist. Die erfindungsgemäße Profil-Trägerplatte ist daher auch zum Aufbau von Gehäusen besonders gut geeignet und kann hierbei z.B. für die Boden- und die Deckplatte eines Gehäusemantels für ein elektrisches Gerät vorteilhaft verwendet werden.

Eine im Hinblick auf die gestellten Anforderungen besonders günstige Dimensionierung der Profil-Trägerplatte bzw. deren Profilform ist in den Unteransprüchen angegeben.

Ferner ist es im Hinblick auf die Anwendung eines Einschnapp-Montagesystems zur Führung und Befestigung der Inneneinbauten auf der Profil-Trägerplatte vorteilhaft, wenn zwischen den beiden äußersten Profilrippen und dem jeweiligen Rand der Trägerplatte eine zu den Inneneinbauten hin offene Nut gebildet ist. Auf diese Weise können Rasterschienen, die zum Einhängen von Führungsmitteln in einem bestimmten Rastermaß vorgesehen sind, sichtbar bleibend außerhalb des die Inneneinbauten aufnehmenden Bereiches angeordnet werden. Dazu ist es zweckmäßig, wenn mindestens eine Nut zum Einsetzen einer Rasterschiene mit mindestens einer Hinterschneidung versehen und derart ausgebildet ist, daß die Rasterschiene unter Klemmung in der Nut fixierbar ist. Eine derartige Hinterschneidung kann z.B. von der Außenkontur der entsprechenden C-Profilschiene gebildet sein.

Eine besonders in herstellungs- und wärmeleittechnischer Hinsicht bevorzugte Ausführungsform einer erfindungsgemäßen Profil-Trägerplatte besteht darin, daß in dem die Inneneinbauten aufnehmenden Bereich der Trägerplatte fünf Profilrippen vorgesehen sind. Hierbei sind zweckmäßigerweise zwischen jeweils zwei Profilrippen vier Kühlrippen vorgesehen. Auf diese Weise ergibt sich eine besonders gleichmäßige Profilform mit in günstiger Weise auf den die Inneneinbauten aufnehmenden Bereich verteilt angeordneter Rippenkonstruktion.

Im Hinblick auf die Verwendung einer erfindungsgemäßen Profil-Trägerplatte zum Aufbau eines Gehäuses ist es vorteilhaft, wenn an den zwei zueinander parallelen Rändern der Trägerplatte Materialanhäufungen in Form von zu den Profilrippen hin abgestuften Leisten gebildet sind. Derartige im Vergleich zur Dicke der Profil-Trägerplatte wesentlich dickere Leisten bieten dann bei Verwendung der Trägerplatte als Boden und/oder Deckplatte eines Gehäuses an der Front- und Rückseite des Gehäuses genügend Material für Schraubbefestigungen von Gehäuse-Front- und -Rückwand.

Schließlich ist es im Hinblick auf die Griffigkeit eines aus erfindungsgemäßen Profil-Trägerplatten bestehenden Gerätegehäuses vorteilhaft, wenn auf der Außenseite der Trägerplatte untereinander etwa gleich breite Flachrippen in etwa gleichem Abstand voneinander angeordnet sind. Derartige Flachrippen sind zugleich optisches Gestaltungselement.

Eine erfindungsgemäße Profil-Trägerplatte läßt sich in einfacher Weise herstellen, wenn sie aus einem Aluminium-Strangpreßprofil besteht.

Die Erfindung ist im folgenden anhand eines in der Zeichnung dargestellten Ausführungsbeispiels einer Profil-Trägerplatte und der Anwendung einer solchen Platte beim Aufbau eines Gehäuses für elektrische Geräte näher beschrieben.

Es zeigen

Fig. 1 ein Gehäuse für elektrische Geräte in perspektivischer Darstellung im geöffneten Zustand,

Fig. 2 ein Teilstück einer Profil-Trägerplatte im Querschnitt II-II mit Führungs-, Rast- und Verdrahtungsmitteln für Inneneinbauten und

Fig. 3 einen unbestückten, vergrößert im Querschnitt dargestellten Bruchteil der Profil-Trägerplatte.

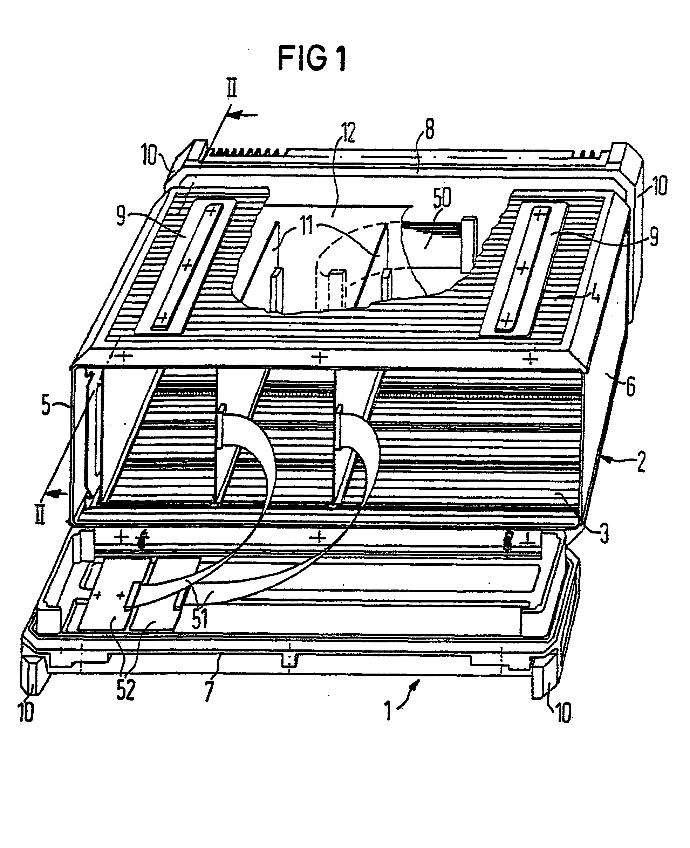

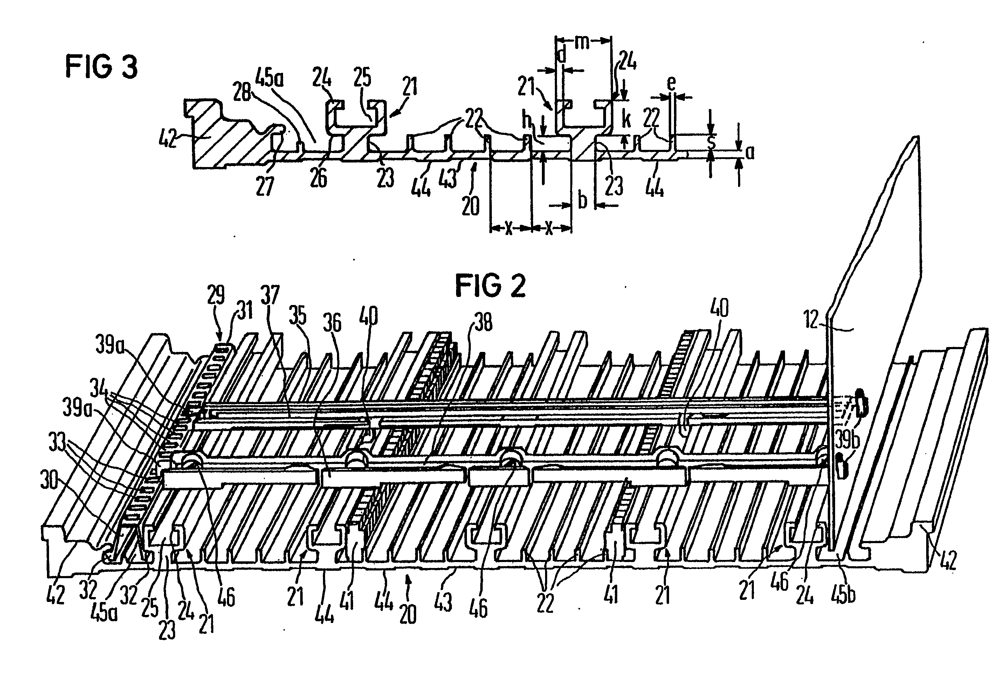

Das Gehäuse 1 in Fig.1 hat einen kastenförmigen Rahmen oder Mantel 2, der aus zwei Mittelteilen, nämlich einer Boden- und einer Deckplatte 3 bzw. 4, sowie aus zwei damit dicht verbundenen Seitenteilen 5,6 besteht und an den beiden offenen Seiten mit einer abschraubbaren oder abklappbaren Frontplatte 7 und einer Rückwand 8 dicht verschließbar ist. Dabei kann die Wasser- und HF-Dichtigkeit des Gehäuses dadurch gewährleistet werden, daß die Mittelteile und die Seitenteile an den vier Kanten durch geeignete Schweißverfahren dicht verbunden sind und eine kombinierte Gummi-Drahtdichtungsschnur jeweils in eine Nut der Frontplatte und der Rückwand eingelegt ist. An der Außenfläche der Deckplatte 4 sind Stapelschienen 9 vorgesehen, um mehrere gleichartige Gehäuse übereinander stapeln zu können. Außerdem ist das Gehäuse 1 noch mit Gummigriffen 10 versehen. Damit ist das Gehäuse in seinem grundsätzlichen Aufbau wie die z.B. in der DE-AS 25 23 292, der DE-PS 25 38 340 und der DE-PS 24 43 122 beschriebene und unter dem Warenzeichen "SIDISET" bekannt gewordene Gehäusebaureihe ausgebildet, wobei für das vorliegende Gehäuse gegebenenfalls einzelne Teile, wie z.B. Frontplatte und Rückwand, Stapelschienen oder Gummigriffe, aus dem bekannten System verwendet werden können. Die die Inneneinbauten, z.B. Leiterplatten 11, Steckbaugruppen oder eine Verdrahtungsplatte 12 tragenden Mittelteile 3 und 4 sind wie bei der bekannten Gehäusebauweise ebenfalls jeweils von einer Profil-Trägerplatte aus einem Aluminium-Strangpreßprofil mit einem zu zwei einander gegenüberliegenden Plattenrändern, hier zur Front- und zur Rückseite, parallelen Profilverlauf in Richtung der Gehäusebreite gebildet. Alle im Gehäusemantel 2 aufgenommenen Inneneinbauten sind über Führungs-, Rast- und Verdrahtungsmittel an den die Boden- und die Deckplatte 3 bzw. 4 bildenden, in besonderer Weise gestalteten Profil-Trägerplatten angeordnet. Der Aufbau einer solchen Profil-Trägerplatte ist im folgenden anhand der Figuren 2 und 3 beschrieben. Diese Figuren zeigen jeweils ein Teil- bzw. ein Bruchstück eines die Bodenplatte 3 bildenden Mittelteils. Das die Deckplatte 4 bildende Mittelteil ist in gleicher Weise ausgestaltet und daher nicht näher dargestellt. Die Profil-Trägerplatte 20 hat einen regelmäßigen Profilverlauf mit gleichmäßig innerhalb des die Inneneinbauten aufnehmenden Bereiches verteilten Profil- und Kühlrippen 21 bzw. 22. Dabei sind auf der hier etwa 2 mm dicken Profil-Trägerplatte 20 fünf Profilrippen 21 vorgesehen, die in gleichem Abstand voneinander angeordnet sind und zu zwei einander parallel gegenüberliegenden Plattenrändern, also zur Front- und zur Rückseite, und zueinander parallel verlaufen. Zwischen jeweils zwei Profilrippen 21 sind vier Kühlrippen 22 vorgesehen, die in gleichem Abstand voneinander angeordnet sind und parallel zu den Profilrippen und zueinander verlaufen. Die Profilrippen 21 bestehen aus einem zur Ebene der Profil-Trägerplatte 20 senkrechten Steg 23 und einer auf diesem Steg liegend angeordneten C-Profilschiene 24 mit einer zu den Inneneinbauten hin offenen T-Nut 25. Der Steg 23 ist im Vergleich zur relativ dünnen Profil-Trägerplatte 20 dick ausgebildet und hat eine Dicke, die etwa dem 3- bis 4-fachen der Dicke a der Trägerplatte ist, während die Höhe h des Steges etwa dem 2- bis 2,5-fachen der Dicke der Trägerplatte ist. Im vorliegenden Ausführungsbeispiel hat der Steg 23 bei einer Plattendicke a von etwa 2 mm eine Dicke b von etwa 7 mm und eine Höhe h von etwa 4,2 mm. Die symmetrisch in bezug auf eine Symmetrielinie des Steges auf diesem liegende C-Profilschiene 24 hat eine Wanddicke d, die etwa dem 1- bis 1,5-fachen der Dicke a der Trägerplatte, also etwa 2 bis 2,5 mm ist. Dabei ist die Höhe k der C-Profilschiene etwa 9,5 mm und ihre Breite m etwa 14 mm. Die Höhe s der Kühlrippen 22 ist etwa gleich der Höhe h des Steges 23, während die Dicke e der Kühlrippen etwa dem 0,5-fachen der Dicke a der Trägerplatte 20, also etwa 1 mm ist. Außerdem weisen die beiden äußersten der zwischen zwei Profilrippen 21 vorgesehenen vier Kühlrippen 22 vom Steg 23 etwa denselben Abstand auf, wie die vier Kühlrippen voneinander. Durch diese Anordnung und Ausbildung von Profil- und Kühlrippen ist eine große Oberfläche zur Wärmeabsorption gebildet. Zudem wird dadurch eine hohe Formstabilität bei möglichst geringem Gewicht der Profil-Trägerplatte erreicht. Außerdem bietet die Form der C-Profilschiene 24 vielfältige variable Befestigungsmöglichkeiten für die Inneneinbauten bzw. deren Führungs- und Rastmittel. Die Inneneinbauten können daher wahlweise mittels Gleit- oder Schiebemuttern schraubbar oder schraubenlos mit Hilfe von durch Einrasten oder Einschnappen in den C-Profilschienen 24 zu halternden Rast- und Führungsmitteln an beliebigen Stellen der Profil-Trägerplatte befestigt werden. Damit bilden die C-Profilschienen gleichzeitig auch Montageschienen, welche die Anwendung einer Einschnappmontagetechnik für die Gehäuseeinbauten bzw. deren Führungs- und Rastmittel ermöglichen. Für den Einbau dieser Mittel ist die Profil-Trägerplatte 20 außerhalb des die Inneneinbauten aufnehmenden Bereiches zwischen den beiden äußersten Profilrippen 21 und dem jeweiligen Rand der Trägerplatte an der Front- bzw. an der Rückseite des Gehäuses noch mit einer zu den Inneneinbauten hin offenen Nut 45a bzw. 45b ausgebildet. Diese Nut ist einerseits durch die außenliegende, eine Hinterschneidung 26 bildende Schulter der entsprechenden C-Profilschiene 24 der äußersten Profilrippe 21 und andererseits durch eine hierzu gegenüberliegende Hinterschneidung 27 der Trägerplatte 20 T-förmig gestaltet und weist etwa in ihrer Mitte eine Rippe 28 auf, die gegenüber den Kühlrippen 22 etwas niedriger ist. Die nahe der Gehäusefrontseite befindliche Nut 45a dient zum Einsetzen einer Rasterschiene 29, während in die nahe der Gehäuserückseite befindliche Nut 45b die Verdrahtungsplatte 12 senkrecht zur Trägerplatte stehend und ggf. an der C-Profilschiene 24 der anderen äußersten Profilrippe 21 anliegend eingesetz ist. Die Rasterschiene 29 besteht aus einem im Querschnitt U-förmigen Kunststoffteil, dessen Schenkel 30 etwas nach außen gespreizt sind, so daß sie mit dem Mittelteil 31 einen Winkel von etwas mehr als 90° einschließen. Außerdem sind die Schenkel 30 der Rasterschiene 29 an ihrem freien Ende mit nach außen gerichteten Haken 32 versehen. Damit ist die von oben her in die Nut 45a einsetzbare und mit ihrer Länge der Gehäusebreite entsprechende Rasterschiene 29 unter Klemmung in der Nut fixierbar. Schließlich ist das Mittelteil 31 der Rasterschiene 29 noch mit einer Vielzahl von quer zur Nut 45a verlaufenden, langlochähnlichen Aussparungen 33 ausgebildet, die ein bestimmtes Lochraster, welches durch Ziffern auf den zwischen den Aussparungen 33 stehenbleibenden Stegen 34 gekennzeichnet werden kann, zum Einsetzen von Führungsschienen 35 aus Kunststoff und/oder Führungsschienen 36 aus Metall bilden. Die Führungsschienen 35,36 haben eine Führungsnut 37 bzw. 38 für die Inneneinbauten, z.B. zum Einschieben von Leiterplatten 11. Außerdem sind die Führungsschienen 35, 36 an beiden Enden mit auf die Trägerplatte 20 zu gerichteten Haken 39a bzw. 39b versehen. Damit können die Führungsschienen 35,36 mit dem Haken 39a an dem einen Ende in das Lochraster der Rasterschiene 29 und mit dem Haken 39b an dem anderen Ende in ein Loch der Verdrahtungsplatte 12 eingehängt werden, wodurch im Zusammenwirken mit der in Fig.2 nicht dargestellten, in gleicher Weise ausgebildeten Deckplatte 4 des Gehäuses 1 gleichzeitig die schraubenlose Halterung der Verdrahtungsplatte 12 in der Nut 45b bewirkt wird. Die schraubenlose Halterung der Kunststoff-Führungsschiene 35 erfolgt durch zwei an deren Unterseite, also an der der Trägerplatte 20 zugewandten Seite vorgesehene Haken 40, welche aufgrund der vorteilhaften Ausbildung der C-Profilschienen 24 in diese einschnappen. In diesem Bereich können an den entsprechenden Profilrippen 21 anliegende, ebenfalls mit einem Teilungsraster ausgebildete Stützschienen 41 in den Raum zwischen der betreffenden C-Profilschiene und der benachbarten Kühlrippe eingesetzt werden. Lediglich für den Fall, daß aus Gründen der Wärmeableitung Führungsschienen 36 aus Metall vorgesehen werden, ist es zweckmäßig, diese z.b. an drei C-Profilschienen 24 mit Hilfe von Schrauben 46 und in die C-Profilschienen einsetzbarer Gleitmuttern zu befestigen. Die C-Profilschienen sind somit sowohl für eine schraubenlose als auch für eine schraubbare Befestigung von Führungsschienen 35, 36 in geeigneter Weise ausgebildet.

Schließlich ist die Profil-Trägerplatte 20 an den zwei zueinander parallenlen Rändern an der Gehäusefront- bzw. an der Gehäuserückseite noch mit Materialanhäufungen in Form von zu den Profilrippen 21 hin abgestuften Leisten 42 ausgebildet, deren Oberseite etwa bündig mit der Oberseite der C-Profilschienen ist. Diese Leisten können Schrauben oder andere Befestigungsmittel für Gehäusefrontplatte und Gehäuserückwand aufnehmen.

Außerden ist die Profil-Trägerplatte 20 auf der Außenseite 43 noch mit untereinander etwa gleich breiten Flachrippen 44 ausgebildet, die in etwa im gleichen Abstand voneinander angeordnet sind. Dabei sind die Flachrippen 44 jeweil im Bereich der Stege 23 der Profilrippen 21 und zwischen den Stegen jeweils zwischen zwei Kühlrippen 22 angeordnet und hier etwa 0,3 bis 0,6 mm dick.

Die Verdrahtungstechnik ist bei dem Gehäse in Fig.1 ohne Kabelbaum in zwei Ebenen infolgender Weise ausgeführt. Alle Leiterplatten 11 sind über die gemeinsame Verdrahtungsplatte 12 zusammengeschaltet. Hierzu sind die Verdrahtungsplatte 12 und die Leiterplatten 11 mit entsprechenden Steckerleisten und Steckern ausgebildet. Die Verdrahtungsplatte 12 ist über ein mit entsprechenden Steckern ausgebildetes Bandkabel 50 an die in die Rückwand 8 integrierte Stromversorgung geführt. An der Vorderseite der Leiterplatten 11 sind ebenfalls über mit Steckern ausgeildete Bandkabel 51 Signal- und Steuerleitungen aus dem Gehäuse heraus und an in die Frontplatte 7 integrierte Baugruppen mit Bedien- und Anschlußelementen herangeführt. Bedarfsweise können mehrere Stecker und Bandleitungen zu einer Funktions- bzw. Prüfeinheit 52 zusammengeführt bzw. mehrere Stecker der Frontplatte 7 über eine Leiterplatte verbunden und mit den Bandkabeln 51 an die Leiterplatten 11 geführt werden. Die Verdrahtung insgesamt ist also einfach und servicefreundlich so aufgebaut, daß der Betrieb des Gerätes auch bei abgeklappter Frontplatte bzw. Rückwand möglich ist.

## Patentansprüche

1. Profil-Trägerplatte für mit wärmeerzeugenden elektrischen Bauelementen versehene Inneneinbauten, wie z.B. Leiterplatten oder Baugruppen, insbesondere der Nachrichtentechnik, z.B. Bodenplatte für einen Gehäusemantel eines elektrischen Gerätes, mit zu zwei einander parallel gegenüberliegenden Plattenrändern parallelen Profilschienen, die mit einer zu den Inneneinbauten hin offenen T-Nut ausgebildet sind und mit zueinander und zu den Profilschienen parallelen Kühlrippen, dadurch gekennzeichnet, daß in dem die Inneneinbauten (11) aufnehmenden Bereich der Trägerplatte (20) mindestens drei Profilrippen (21) für Führungsmittel (35, 36) und/oder Befestigungsmittel (46) der Inneneinbauten (11) vorgesehen und in gleichem Abstand voneinander angeordnet sind, daß die Profilrippen (21) aus einem im Vergleich zur Dicke der relativ dünnen Trägerplatte (20) dicken, zur Plattenebene senkrechten Steg (23) und einer auf dem Steg liegend angeordneten C-Profilschiene (24) bestehen, und daß auf derselben Seite der Trägerplatte (20) zwischen jeweils zwei Profilrippen (21) mehrere Kühlrippen (22) in gleichem Abstand voneinander vorgesehen sind, so daß die Trägerplatte (20) auf ein und derselben Seite eine regelmäßige Profilierung mit gleichmäßig innerhalb des die Inneneinbauten (11) aufnehmenden Bereiches verteilten Profil- und Kühlrippen (21 bzw. 22) aufweist.

2. Profil-Trägerplatte nach Anspruch 1,
**dadurch gekennzeichnet,** daß die C-Profilschiene (24) symmetrisch in Bezug auf eine Symmetrielinie des Steges (23) angeordnet ist.

3. Profil-Trägerplatte nach Anspruch 1 oder 2,
**dadurch gekennzeichnet,** daß die Wanddicke (d) der C-Profilschiene (24) etwa dem 1- bis 1,5-fachen der Dicke (a) der Trägerplatte (20) ist.

4. Profil-Trägerplatte nach einem der Ansprüche 1 bis 3,
**dadurch gekennzeichnet,** daß die Dicke (b) des Steges (23) etwa dem 3- bis 4-fachen der Dicke (a) der Trägerplatte (20) ist.

5. Profil-Trägerplatte nach einem der vorhergehenden Ansprüche, **dadurch gekennzeichnet,** daß die Höhe (h) des Steges (23) etwa dem 2- bis 2,5-fachen der Dicke (a) der Trägerplatte (20) ist.

6. Profil-Trägerplatte nach einem der vorhergehenden Ansprüche, **dadurch gekennzeichnet,** daß die Höhe (l) der Kühlrippen (22) etwa gleich der Höhe (h) des Steges (23) ist.

7. Profil-Trägerplatte nach einem der vorhergehenden Ansprüche, **dadurch gekennzeichnet,** daß die Dicke (e) der Kühlrippen (22) etwa dem 0,5-fachen der Dicke (a) Trägerplatte (20) ist.

8. Profil-Trägerplatte nach einem der vorhergehenden Ansprüche, **dadurch gekennzeichnet,** daß bei einer Dicke (a) der Trägerplatte (20) von etwa 2 mm die Dicke (b) des Steges (23) etwa 7 mm, seine Höhe (h) etwa 4,2 mm, die Höhe (k) der C-Profilschiene (24) etwa 9,5 mm und ihre Breite (m) etwa 14 mm ist.

9. Profil-Trägerplatte nach einem der vorhergehenden Ansprüche, **dadurch gekennzeichnet,** daß zwischen den beiden äußersten Profilrippen (21) und dem jeweiligen Rand der Trägerplatte (20) eine zu den Inneneinbauten (11) hin offene Nut (45a, 45b) gebildet ist.

10. Profil-Trägerplatte nach Anspruch 9,
**dadurch gekennzeichnet,** daß mindestens eine Nut (45a) zum Einsetzen einer Rasterschiene (29) mit mindestens einer Hinterschneidung (26,27) versehen und derart ausgebildet ist, daß die Rasterschiene (29) unter Klemmung in der Nut (45a) fixierbar ist.

11. Profil-Trägerplatte nach einem der vorhergehenden Ansprüche, **dadurch gekennzeichnet,** daß in dem die Inneneinbauten (11) aufnehmenden Bereich der Trägerplatte (20) fünf Profilrippen (21) vorgesehen sind.

12. Profil-Trägerplatte nach einem der vorhergehenden Ansprüche, **dadurch gekennzeichnet,** daß zwischen jeweils zwei Profilrippen (21) vier Kühlrippen (22) vorgesehen sind.

13. Profil-Trägerplatte nach einem der vorhergehenden Ansprüche, **dadurch gekennzeichnet,** daß die beiden äußersten der zwischen zwei Profilrippen (21) vorgesehenen Kühlrippen (22) vom Steg (23) etwa denselben Abstand (x) aufweisen wie alle Kühlrippen (22) zwischen zwei Profilrippen (21) voneinander.

14. Profil-Trägerplatte nach einem der vorhergehenden Ansprüche, **dadurch gekennzeichnet,** daß an den zwei zueinander parallelen Rändern der Trägerplatte (20) Materialanhäufungen in Form von zu den Profilrippen (21) hin abgestuften Leisten (42) gebildet sind.

15. Profil-Trägerplatte nach Anspruch 14,
**dadurch gekennzeichnet,** daß die Oberseite der Leisten (42) etwa bündig mit der Oberseite der C-Profilschiene (24) ist.

16. Profil-Trägerplatte nach einem der vorhergehenden Ansprüche, **dadurch gekennzeichnet,** daß auf der Außenseite (43) der Trägerplatte (20) untereinander etwa gleich breite Flachrippen (44) in etwa gleichem Abstand voneinander angeordnet sind.

17. Profil-Trägerplatte nach Anspruch 16,
**dadurch gekennzeichnet,** daß die Flachrippen (44) jeweils im Bereich der Stege (23) und zwischen den Stegen zwischen jeweils zwei Kühlrippen (22) vorgesehen sind.

18. Profil-Trägerplatte nach einem der vorhergehenden Ansprüche, **dadurch gekennzeichnet,** daß die Trägerplatte (20) aus einem Aluminium-Strangpreßprofil besteht.

**Claims**

1. Profiled supporting plate for interior constructions, provided with heat-producing electrical components, such as, e.g., printed circuit boards or modules, in particular in telecommunications engineering, e.g. a base-plate for a housing shell of an electrical appliance, having profiled mounting rails, which are parallel to two mutually parallel opposite plate edges and are constructed with a T-slot open towards the interior constructions, and having cooling ribs parallel to one another and to the profiled mounting rails, characterized in that at least three profiled ribs (21) for guiding means (35, 36) and/or fastening means (46) of the interior constructions (11) are provided in the region of the supporting plate (20) accommodating the interior constructions (11) and are arranged at the same separation from one another, in that the profiled ribs (21) consist of a web (23), which is thicker by comparison with the thickness of the relatively thin supporting plate (20) and perpendicular to the plane of the plate, and a C-profiled mounting rail (24) arranged recumbent on the web, and in that a plurality of cooling ribs (22) are provided, at the same separation from one another, on the same side of the supporting plate (20) between in each case two profiled ribs (21), so that the supporting plate (20) has on one and the same side a regular profiling with profiled and cooling ribs (21 or 22) distributed uniformly inside the region accommodating the interior constructions (11).

2. Profiled supporting plate according to Claim 1, characterized in that the C-profiled mounting rail (24) is arranged symmetrically with regard to a line of symmetry of the web (23).

3. Profiled supporting plate according to Claim 1 or 2, characterized in that the wall thickness (d) of the C-profiled mounting rail (24) is approximately 1 to 1.5 times the thickness (a) of the supporting plate (20).

4. Profiled supporting plate according to one of Claims 1 to 3, characterized in that the thickness (b) of the web (23) is approximately 3 to 4 times the thickness (a) of the supporting plate (20).

5. Profiled supporting plate according to one of the preceding claims, characterized in that the height (h) of the web (23) is approximately 2 to 2.5 times the thickness (a) of the supporting plate (20).

6. Profiled supporting plate according to one of the preceding claims, characterized in that the height (l) of the cooling ribs (22) is approximately equal to the height (h) of the web (23).

7. Profiled supporting plate according to one of the preceding claims, characterized in that the thickness (e) of the cooling ribs (22) is approximately 0.5 times the thickness (a) of the supporting plate (20).

8. Profiled supporting plate according to one of the preceding claims, characterized in that given a thickness (a) of the supporting plate (20) of approximately 2 mm, the thickness (b) of the web (23) is approximately 7 mm, its height (h) is approximately 4.2 mm, the height (k) of the C-profiled mounting rail (24) is approximately 9.5 mm and its width (m) is approximately 14 mm.

9. Profiled supporting plate according to one of the preceding claims, characterized in that a slot (45a, 45b) open towards the interior constructions (11) is formed between the two outermost profiled ribs (21) and the respective edge of the supporting plate (20).

10. Profiled supporting plate according to Claim 9, characterized in that at least one slot (54a) with at least one undercut (26, 27) is provided for the insertion of a slotted rail (29), and is constructed in such a way that the slotted rail (29) can be fixed in that slot (45a) by clamping.

11. Profiled supporting plate according to one of the preceding claims, characterized in that five profiled ribs (21) are provided in the region of the supporting plate (20) accommodating the interior constructions (11).

12. Profiled supporting plate according to one of the preceding claims, characterized in that four cooling ribs (22) are provided between two profiled ribs (21) in each case.

13. Profiled supporting plate according to one of the preceding claims, characterized in that the two outermost of the cooling ribs (22) provided between two profiled ribs (23) as the mutual separation of all cooling ribs (22) between two profiled ribs (21).

14. Profiled supporting plate according to one of the preceding claims, characterized in that material assemblages in the form of strips (42) stepped towards the profiled ribs (21) are formed at the two mutually parallel edges of the supporting plate (20).

15. Profiled supporting plate according to Claim 14, characterized in that the upper side of the strips (42) is approximately flush with the upper side of the C-profiled mounting rail (24).

16. Profiled supporting plate according to one of the preceding claims, characterized in that flat ribs (44) of approximately the same width are arranged below one another at approximately the same separation from one another on the outside (43) of the supporting plate (20).

17. Profiled supporting plate according to Claim 16, characterized in that the flat ribs (44) are provided in each case in the region of the webs (23) and between the webs between in each case two cooling ribs (22).

18. Profiled supporting plate according to one of the preceding claims, characterized in that the supporting plate (20) consists of an extruded aluminium profile.

**Revendications**

1. Plaque de support profilée pour des structures intérieures encastrées pourvues de composants électriques dégageant de la chaleur, comme par exemple des plaquettes à circuits imprimés ou des modules, notamment de la technique de la transmission d'informations, par exemple une plaque de base pour l'enveloppe formant boîtier d'un appareil électrique, comportant des rails profilés parallèles à deux bords parallèles et opposés de la plaque et comportant une rainure en T ouverte en direction des structures intérieures encastrées, et comportant des ailettes de refroidissement parallèles entre elles et aux rails profilés, caractérisée par le fait que dans la partie de la plaque de support (20), qui loge les structures intérieures encastrées (11), au moins trois nervures profilées (21) sont prévues pour des moyens de guidage (35, 36) et/ou des moyens de fixation (46) des structures intérieures encastrées (11) et sont disposées à une même distance les unes des autres, que les nervures profilées (21) sont constituées par une barrette (23) d'une épaisseur supérieure à celle de la plaque de support relativement mince (20) et perpendiculaire au plan de la plaque, et par un rail profilé en C (24) disposé à plat sur la barrette, et que du même côté de la plaque de support (20), plusieurs ailettes de refroidissement (22) séparées par une même distance sont prévues entre respectivement deux nervures profilées (21) de sorte que la plaque de support (20) comporte, sur un même côté, un profil régulier incluant des nervures profilées au des ailettes de refroidissement (21 ou 22), réparties uniformément à l'intérieur de la zone logeant les structures intérieures encastrées (11).

2. Plaque de support profilée suivant la revendication 1, caractérisée par le fait que le rail profilé en C (24) est disposé symétriquement par rapport à un axe de symétrie de la barrette (23).

3. Plaque de support profilée suivant la revendication 1 ou 2, caractérisée par le fait que l'épaisseur (d) de la paroi du rail profilé en C (24) est comprise entre environ 1 et 1,5 fois l'épaisseur (a) de la plaque de support (20).

4. Plaque de support profilée suivant l'une des revendications 1 à 3, caractérisée par le fait que l'épaisseur (b) de la barrette (23) est comprise approximativement entre 2 et 4 fois l'épaisseur (a) de la plaque de support (20).

5. Plaque de support profilée suivant l'une des revendications précédentes, caractérisée par le fait que la hauteur (h) de la barrette (23) est comprise approximativement entre 2 et 2,5 fois l'épaisseur (a) de la plaque de support (20).

6. Plaque de support profilée suivant l'une des revendications précédentes, caractérisée par le fait que la hauteur (l) des ailettes de refroidissement (22) est égale approximativement à la hauteur (h) de la barrette (23).

7. Plaque de support profilée suivant l'une des revendications précédentes, caractérisée par le fait que l'épaisseur (e) des ailettes de refroidissement (22) est égale approximativement à 0,5 fois l'épaisseur (a) de la plaque de support (20).

8. Plaque de support profilée suivant l'une des revendications précédentes, caractérisée par le fait que, pour une épaisseur (a) de la plaque de support (20) égale à environ 2 mm, l'épaisseur (b) de la barrette (3) est égale à environ 7 mm, sa hauteur (h) est égale à environ 4,2 mm, la hauteur (k) du rail profilé en C (24) est égale à environ 9,5 mm et sa largeur (m) est égale à environ 14 mm.

9. Plaque de support profilée suivant l'une des revendications précédentes, caractérisée par le fait qu'une rainure (45a, 45b) s'ouvrant en direction des structures intérieures encastrées (11) est formée entre les deux nervures profilées les plus extérieures (21) et le bord respectif de la plaque de support (20).

10. Plaque de support profilée suivant la revendication 9, caractérisée par le fait qu'au moins une rainure (45a) utilisée pour l'insertion d'un rail d'encliquetage (29) comporte au moins une partie en dépouille (26, 27) et est agencée de telle sorte que le rail d'encliquetage (29) peut être en étant coincé dans la rainure (45a).

11. Plaque de support profilée suivant l'une des revendications précédentes, caractérisée par le fait que cinq nervures profilées (21) sont prévues dans la partie de la plaque de support (20) recevant les structures intérieures encastrées (11).

12. Plaque de support profilée suivant l'une des revendications précédentes, caractérisée par le fait que quatre ailettes de refroidissement (22) sont prévues entre deux nervures profilées respectives (21).

13. Plaque de support profilée suivant l'une des revendications précédentes, caractérisée par le fait que les deux ailettes de refroidissement les plus extérieures, qui font partie des ailettes de refroidissement (22) prévues entre deux nervures profilées (22), sont séparées de la barrette (23) approximativement par la même distance (x) que celles qui séparent toutes les ailettes de refroidissement (22) entre deux nervures profilées (21).

14. Plaque de support profilée suivant l'une des revendications précédentes, caractérisée par le fait que des accumulations de matière sont réalisées sous la forme de barrettes (42) étagées en direction des nervures profilées (21), sur deux bords, parallèles entre eux, de la plaque de support (20).

15. Plaque de support profilée suivant la revendication 14, caractérisée par le fait que la face supérieure des barrettes (42) est approximativement de niveau avec la face supérieure du rail profilé en C (24).

16. Plaque de support profilée suivant l'une des revendications précédentes, caractérisée par le fait que des nervures planes (44) possédant approximativement une même largeur sont disposées, approximativement à la même distance les unes des autres, sur la face extérieure (43) de la plaque de support (20).

17. Plaque de support profilée suivant la revendication 16, caractérisée par le fait que les nervures plates (44) sont prévues respectivement au niveau des barrettes (23) et entre les barrettes situées entre deux ailettes de refroidissement respectives (22).

18. Plaque de support profilée suivant l'une des revendications précédentes, caractérisée par le fait que la plaque de support (20) est constituée par un profilé extrudé en aluminium.

# FIG 1

**FIG 3**

**FIG 2**

EP 0 217 160 B1